# EUROPÄISCHE PATENTSCHRIFT

(11) **EP 1 340 989 B1**
(45) Veröffentlichungstag und Bekanntmachung des Hinweises auf die Patenterteilung: **13.07.2005**
(21) Anmeldenummer: 03003465.6
(22) Anmeldetag: 14.02.2003
(51) Int. Cl.: G01R 27/20, G01M 3/16

(54) **Vorrichtung und Verfahren zur Messung von Potenzialen im Erdreich**
Device and method for measuring potentials in the soil
Dispositif et procédé de mesure du potentiel du sol

(30) Priorität: 14.02.2002 DE 10206521
(43) Veröffentlichungstag der Anmeldung: 03.09.2003
(73) Patentinhaber: Progeo Monitoring GmbH, 14979 Grossbeeren (DE)
(72) Erfinder: Rödel, Petra, 14532 Stahnsdorf (DE)
(74) Vertreter: COHAUSZ & FLORACK

(56) Entgegenhaltungen:
- WO-A-00/67047
- DE-U- 29 521 991
- TW-A- 436 617
- US-A- 3 975 676
- US-A- 6 064 210

## Beschreibung

Die Erfindung betrifft eine Vorrichtung sowie ein Verfahren zur ortsbezogenen Messung von elektrischen Eigen- und Fremdpotenzialen im Erdreich. Die Erfindung lässt sich insbesondere bei der Überwachung von Deponieabdichtungen auf Dichtigkeit und der Ortung eventueller Leckagen anwenden.

In der Geoelektrik, in der Bodenkunde sowie im Umweltschutz kommt der Erfassung von elektrischen Eigen- und Fremdpotenzialen im Erdreich erhebliche Bedeutung zu. Nach bisherigem Stand der Technik wird dabei, je nach Aufgabenstellung im Einzelfall, durch in der Regel mindestens zwei entfernt voneinander angeordnete Einspeiseelektroden ein Strom in das Erdreich eingespeist und über eine oder mehrere Sonden die Potenzialverteilung im Strömungsfeld des stromdurchflossenen Erdreichs gemessen, erfasst und dann hinsichtlich der Zielgröße bewertet.

Bei größeren Untersuchungsobjekten erfordert dies in der Regel entweder, wenn es sich um oberflächennahe Messungen handelt, sehr arbeits- und zeitaufwendige manuelle Messungen, da die Sonden ständig manuell umgesetzt und in ihrer Lage neu eingemessen werden müssen, um die Potenzialverteilung zu erfassen, oder es ist, bei der Erfassung von unterirdisch im Erdreich liegenden großflächigen Objekten, eine große Anzahl diskreter Messpunkte einschließlich der zugehörigen Verkabelung zu installieren und zu betreiben, was einen hohen messtechnischapparativen und einen großen einbautechnischen Aufwand zur Folge hat, um derartige Messungen durchzuführen.

Dies soll am Beispiel der Überwachung einer mittleren Deponieabdichtung mit 50.000 m² Gesamtfläche verdeutlicht werden.

Bei annähernd quadratischem Grundriss hat die Deponie eine Seitenlänge von ca. 225 m. Nach bisherigem Stand der Technik wird die Überwachung einer solchen Abdichtung mit einem Messraster von 5x5 m durchgeführt. Hierzu werden diskrete Sensoren einschließlich zugehöriger Verkabelung unterhalb der Abdichtung verlegt. Jeder Messpunkt ist dabei in seiner Lage tachymetrisch einzumessen. Die Verkabelung wird an einer oder mehreren Stellen am Rand der Abdichtung zusammengeführt, um die Messeinheit anschliessen zu können.

Im vorgenannten Beispiel werden insgesamt 2.000 Sensoren benötigt, um die Abdichtung messtechnisch zu erfassen. Die durchschnittliche Leitungslänge des einzelnen Sensors beträgt dabei ca. 112,50 m, so dass insgesamt ca. 225 km Leitungen verlegt werden müssen. Zur Durchführung der Messungen müssen, gegebenenfalls in mehreren Etappen, die Messpunkte auf die Messeinheit aufgeschaltet werden.

Die DE 295 21 991 U1 offenbart eine Vorrichtung zur Überwachung von Deponieabdichtungen, mit einem sich flächig erstreckenden Sensorelement zur Widerstandsmessung und mit einer daran angeschlossenen Auswerteelektronik. Das Sensorelement ist als Geotextil mit einer Vielzahl von gekräuselten Sensordrähten ausgebildet, die in zumindest zwei Sensordrahtgruppen ein flächiges Sensordraht-Widerstandsnetzwerk bildend angeordnet sind, wobei die Sensordrähte der einen Sensorgruppe die Sensordrähte der anderen Sensorgruppe berührungslos kreuzen.

In der US 3,975,676 sind ein System und ein Verfahren zur Erfassung von elektrischen Parametern großer Materialproben in-situ, insbesondere zur Exploration von unterirdischen Erzkörpern beschrieben. Dabei werden lineare Bohrlochelektroden in einem rechteckigen Raster angeordnet und positive sowie negative elektrische Potenziale an aufeinanderfolgenden Elektroden angelegt, um Symmetrieebenen zu erzeugen, welche mehrere "Zellen" definieren. Ein vorgegebener Anteil von elektrischem Strom fließt dabei von einer Elektrode ab und erreicht eine entsprechende Elektrode, wobei eine Impedanzcharakteristik für jede Zelle ermittelt wird. Das Vorhandensein einer Inhomogenität und Anisotropie wird durch ungleiche Ströme in geometrisch äquivalenten Zellen reflektiert.

Die WO 00/67047 A1 offenbart ein Verfahren zur Erkundung einer geologischen Formation, in die ein verrohrtes Bohrloch eingebracht ist. Bei dem Verfahren wird mittels mehrerer im Bohrloch beabstandet zueinander angeordneter Elektroden der elektrische Widerstand der Formation gemessen.

Aus der US 6,064,210 ist eine Vorrichtung zur Bohrlochvermessung bekannt, mit der der elektrische Widerstand durchbohrter Erdformationen während des Bohrens gemessen werden kann. Die Vorrichtung ist in einem Bohrgestänge nahe des Bohrmeißels angeordnet.

Aufgabe der vorliegenden Erfindung ist es, eine Vorrichtung und ein Verfahren zur Messung von Potenzialen im Erdreich zur Verfügung zu stellen, die ohne die vorgenannten Nachteile mobiler oder stationärer Messverfahren auskommen, zumindest in einer Koordinatenrichtung eine bessere Ortsauflösung bieten und dabei deutlich kostengünstiger ausgeführt werden können.

Diese Aufgabe wird erfindungsgemäß durch eine Vorrichtung mit den Merkmalen des Anspruchs 1 und durch ein Verfahren mit den Merkmalen des Anspruchs 7 gelöst.

Bevorzugte und vorteilhafte Ausgestaltungen der Erfindung sind in den Unteransprüchen gekennzeichnet.

Grundlage der Erfindung ist also ein langerstreckter flexibler Hohlkörper aus Kunststoff, vorzugsweise ein Rohr oder ein Schlauch, der ganz oder teilweise eine elektrisch leitfähige Wandung, vorzugsweise aus elektrisch leitfähigem Kunststoff, aufweist. Wird dieser Schlauch im Erdreich verlegt, so entsteht durch das elektrische Strömungsfeld, das in an sich bekannter Weise zur Durchführung des Messverfahrens mittels Geberelektroden dem Erdreich aufgeprägt wird, in der erdberührten Wandung des Hohlkörpers ein elektrisches Potenzial, das dem Erdpotenzial an gleicher Stelle entspricht. Ist die Wandung des Hohlkörpers elektrisch leitfähig, so ist wiederum das elektrische Potenzial an der Innenseite der Wandung proportional dem Potenzial an der Außenwand. Mit einer längsverschiebbaren Sonde kann das Potenzial in einfacher Weise ortsbezogen abgetastet und gemessen werden.

Um eine Dämpfung der ortsbezogen sehr unterschiedlichen Potenziale entlang des Hohlkörpers zu vermeiden, sollte der Hohlkörper entweder über sich in Längsrichtung abwechselnde Bereiche mit leitfähiger und nicht leitfähiger Wandung verfügen und/oder es sollte die Leitfähigkeit des Mantels in Längsrichtung so eingestellt werden, dass sie gleich oder kleiner ist, als die Leitfähigkeit des geoelektrischen wirksamen Volumens im Umfeld des Hohlkörpers.

Die Messung des Nutzpotenzials innerhalb des Hohlkörpers kann auf unterschiedliche Art und Weise erfolgen.

Im einfachsten Fall wird mittels eines Schleifkontaktes, der über eine mitlaufende elektrisch isolierte Leitung mit der Messeinheit verbunden ist, der ortsbezogene Potenzialverlauf entlang des Hohlkörpers ermittelt. Die Leitung kann dabei gleichzeitig die Aufgabe der Zug- bzw. Schubkraftübertragung einer vom freien Ende der Leitung aufgeprägten Verschiebungskraft übernehmen. Ist die Länge der jeweils leitfähigen und nicht leitfähigen Abschnitte des Hohlkörpers bekannt, so kann durch Auszählen der Fenster mit und ohne Potenzialverbindung, die die verschiebbare Sonde bei der Verschiebung überstrichen hat, in einfacher Weise die zu einem Potenzialmesswert zugehörige Position im Hohlkörper bestimmt werden. Diese Position kann allerdings auch durch eine Längenmessung oder Längenmesseinrichtung vom Zug- oder Schubende des Rohres aus bestimmt werden.

Anstelle einer mittels Schub- bzw. Zugdraht verschiebbaren Sonde kann das ortsbezogene Potenzial auch dadurch zur Messeinheit übertragen werden, dass ein nicht oder abschnittsweise gegenüber dem Innenraum des flexiblen Hohlkörpers isolierend ausgebildeter Kontaktdraht, vorzugsweise aus korrosionsbeständigem Metall, so in Längsrichtung des Hohlkörpers angeordnet wird, dass ein direkter elektrischer Kontakt mit den leitfähigen Wandungsbereichen des Hohlkörpers sicher vermieden wird. Dieser Draht wird an einem freien Ende des Hohlkörpers mit dem Messeingang der Auswerteeinheit verbunden.

Um nun den Potenzialverlauf entlang des Hohlkörpers zu messen, wird eine leitfähige Flüssigkeit, die nach Möglichkeit nur eine geringe Benetzung mit dem Hohlkörper und dem Kontaktdraht aufweist, in den Hohlkörper eingefüllt, wobei nur so viel Flüssigkeit in den Hohlkörper eingefüllt wird, dass sich eine im Verhältnis zur Länge des Hohlkörpers nur sehr kurze Flüssigkeitssäule von zum Beispiel einigen Zentimetern oder Dezimetern Länge ausbildet. Als Kontaktflüssigkeit kann zum Beispiel Quecksilber verwendet werden. Durch die Kontaktflüssigkeit wird lokal eine elektrisch leitfähige Verbindung zwischen dem Kontaktdraht und der Wandung hergestellt, so dass das Nutzpotenzial von der Wandung auf den Draht und damit auf die Messeinheit übertragen wird. Der lichte Querschnitt des Hohlkörpers, die Viskosität sowie die'Oberflächenspannung der Flüssigkeit gegenüber der Wandung des Hohlkörpers sowie gegenüber dem Kontaktdraht sind dabei so aufeinander abzustimmen, dass ein Abriss der Flüssigkeitssäule inklusive undefinierter Tropfenbildung im Hohlkörper ebenso wie ein Zerlaufen der Flüssigkeitssäule im Bereich weitgehend horizontal verlaufender Messbereiche vermieden wird.

Die Verschiebung der Flüssigkeitssäule in Längsrichtung des Hohlkörpers kann auf unterschiedliche Weise erfolgen. Im einfachsten Fall ist der Hohlkörper mit ausreichendem Gefälle verlegt, so dass die Flüssigkeitssäule aufgrund der Schwerkraft von einem Hochpunkt zu einem Tiefpunkt fließt. Hierbei kann die Geschwindigkeit des Durchfließens in einfacher Weise durch eine Drosselung der verdrängten oder nachströmenden Luftsäule beeinflusst werden. In einer weiteren Ausgestaltung des Verfahrens wird die Flüssigkeitssäule hydraulisch oder pneumatisch durch den Hohlkörper bewegt, indem der Hohlkörper vor oder hinter der aus der Kontaktflüssigkeit bestehenden Flüssigkeitssäule mit einer unter Über- bzw. Unterdruck stehenden Flüssigkeits- oder Druckgassäule beaufschlagt wird. Im Fall einer hydraulischen Verschiebung sollte die verwendete Hydraulikflüssigkeit vorzugsweise nur eine sehr niedrige, idealerweise keine elektrische Leitfähigkeit und nur eine möglichst geringe Benetzung mit der Hohlkörperwandung, dem Kontaktdraht und der Kontaktflüssigkeit aufweisen.

Als Hydraulikflüssigkeit wird eine Flüssigkeit gewählt, die sich mit der Kontaktflüssigkeit nicht vermischt.

Die Positionsbestimmung der Kontaktsäule innerhalb des Hohlkörpers kann in dieser Verfahrensvariante auf unterschiedliche Weise erfolgen.

Zunächst kann, wie bereits im Zusammenhang mit der Kontaktsonde beschrieben, die Position durch Auszählen sich abwechselnder Bereiche leitfähiger und damit erdpotenzialverbundener und nicht erdpotenzialverbundener Wandungsbereiche erfolgen. In gleicher Weise kann auch der Kontaktdraht mit sich abwechselnden isolierten und nicht isolierten Abschnitten ausgebildet werden und so der Kontaktdraht für die Positionsbestimmung genutzt werden.

In einer anderen Ausgestaltung kann der Kontaktdraht oder ein weiterer im Hohlkörper mitgeführter, gegenüber dem Kontaktdraht und der Hohlkörperwandung isoliert angeordneter Draht als längenproportionales Widerstandselement ausgebildet werden, wobei die Position der Kontaktflüssigkeit im Hohlkörper aus dem längenabhängigen Schleifenwiderstand Kontaktdraht-Kontaktflüssigkeit gegen Erde oder aus dem positionsabhängigen Widerstandsverhältnis der von beiden freien Enden des Widerstandselements über die Kontaktflüssigkeit gegen Erde gemessenen Schleifenwiderstände bestimmt wird.

Eine weitere Möglichkeit der Positionsbestimmung der Kontaktflüssigkeit besteht in der Messung des zur Verschiebung eingesetzten Volumens an Hydraulikflüssigkeit bzw. Druckgas oder durch Messung des zu bzw. ausströmenden Luftvolumens, zum Beispiel bei Betrieb des Systems im freien Gefälle.

Wird zusätzlich zur Messung des Volumenstroms im Zusammenhang mit der Positionsbestimmung der Druckverlauf im Hohlkörper in Abhängigkeit von der Position der Kontaktflüssigkeit bestimmt, wobei strömungsbedingte Druckeinflüsse zu kompensieren sind, so kann neben der Position auch die Höhenlage der Kontaktflüssigkeit gegenüber einem Bezugsnormal und der Neigungswinkel an der Stelle der Kontaktflüssigkeit bestimmt werden.

Wird mit dem erfindungsgemäßen Verfahren die im Beispiel angeführte Abdichtung überwacht, so werden hierzu bei gleichem seitlichen Abstand der Messstrecken von 5 m insgesamt ca. 45 Messleitungen mit einer Gesamtlänge von 10.125 m benötigt. Anstelle eines vielkanaligen Messstellenumschalters wird für die Messung nur ein Messkanal benötigt, wobei zumindest entlang der Messstrecke zumindest prinzipiell eine beliebig feine Auflösung erzielt wird.

Gleichzeitig kann das Verfahren benutzt werden, um Setzungen des jeweiligen Bauwerks, zum Beispiel einer Deponieabdichtung, mit zu erfassen.

Nachfolgend wird die Erfindung anhand einer mehrere Ausführungsbeispiele darstellenden Zeichnung näher erläutert. Es zeigen in schematischer Darstellung:
- Fig. 1: eine perspektivische Darstellung eines Abschnitts einer Deponieabdichtung mit mehreren schlauchförmigen, im Wesentlichen parallel zueinander angeordneten Hohlkörpern,
- Fig. 2: eine perspektivische Darstellung eines Abschnitts eines schlauchförmigen Hohlkörpers aus elektrisch leitfähigem Material mit einem an der Innenseite des Hohlkörpers anliegenden, entlang des Hohlkörpers verschiebbaren Schleifkontakt,
- Fig. 3: eine perspektivische Darstellung eines Abschnitts eines schlauchförmigen Hohlkörpers, der sich abwechselnde elektrisch leitfähige und elektrisch nicht leitfähige Wandungsabschnitte aufweist und wiederum mit einem an seiner Innenseite anliegenden, in Längsrichtung verschiebbaren Schleifkontakt versehen ist,
- Fig. 4: eine perspektivische Darstellung eines Abschnitts eines schlauchförmigen Hohlkörpers, der eine elektrisch leitfähige Wandung aufweist und im Inneren mit einem in Längsrichtung verlaufenden, elektrisch leitfähigen Kontaktleiter versehen ist,
- Fig. 5: eine perspektivische Darstellung eines Abschnitts eines Hohlkörpers gemäß Fig. 4, der jedoch im Gegensatz dazu axial sich abwechselnde elektrisch leitfähige und elektrisch nicht leitfähige Wandungsabschnitte aufweist,
- Fig. 6: eine perspektivische Darstellung eines Abschnitts eines Hohlkörpers gemäß Fig. 4, wobei der Kontaktleiter sich abwechselnde elektrisch isolierte Abschnitte und elektrisch nicht isolierte Abschnitte aufweist,
- Fig. 7: eine perspektivische Darstellung eines Abschnitts eines schlauchförmigen Hohlkörpers mit einem darin koaxial angeordneten, zentrisch gehaltenen Kontaktleiter,
- Fig. 8: eine perspektivische Darstellung eines Abschnitts eines schlauchförmigen Hohlkörpers, der radial in einen elektrisch leitfähigen und einen elektrisch nicht leitfähigen Wandungsabschnitt unterteilt ist und an der Innenseite des elektrisch nicht leitfähigen Wandungsabschnittes einen elektrisch leitfähigen Kontaktleiter aufweist,
- Fig. 9: einen Querschnitt durch einen schlauchförmigen, aus elektrisch leitfähigem Material hergestellten Hohlkörper, in dem ein langgestreckter, elektrisch nicht leitfähiger, im Querschnitt sichelförmiger Halter koaxial verläuft, der an seiner Innenseite einen elektrisch leitfähigen Kontaktleiter trägt, und
- Fig. 10: einen Querschnitt durch einen schlauchförmigen, aus elektrisch leitfähigem Material hergestellten Hohlkörper mit einem elektrisch nicht leitfähigen, im Querschnitt sichelförmigen Halter gemäß Fig. 9, der im Gegensatz dazu jedoch an seiner Innenseite einen weiteren elektrischen Leiter als längenproportionales Widerstandselement aufweist.

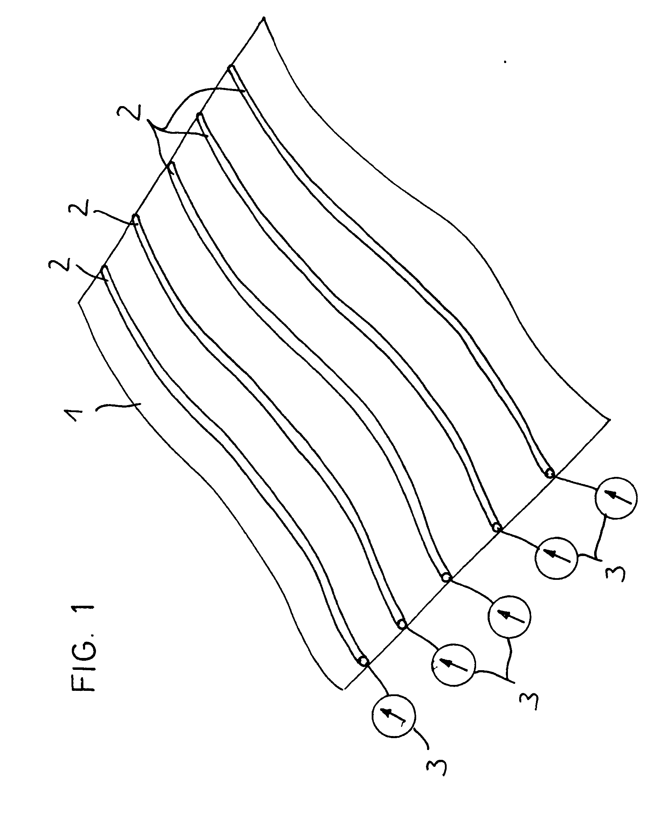

In Fig. 1 ist schematisch ein Abschnitt einer Deponieabdichtung 1 dargestellt, die beispielsweise aus miteinander verschweißten und/oder verklebten Kunststoffdichtungsbahnen hergestellt ist. Die Kunststoffdichtungsbahnen wirken elektrisch isolierend. Die Deponieabdichtung 1 ist mit einer Vielzahl von rohr- oder schlauchförmigen Hohlkörpern 2 versehen, die im Wesentlichen parallel zueinander angeordnet sind. Die schlauchförmigen Hohlkörper 2 definieren jeweils eine Messstrecke und weisen eine Wandung auf, die jeweils zumindest abschnittsweise elektrisch leitfähig ausgebildet ist. Die schlauchförmigen Hohlkörper sind aus elektrisch leitfähigem Kunststoff gefertigt.

In jedem der schlauchförmigen Hohlkörper 2 ist ein entlang des Hohlkörpers verschiebbarer Messkontakt angeordnet bzw. ausgebildet, der an der Innenseite des jeweiligen Hohlkörpers 2 anliegt. Ferner ist jedem Hohlkörper 2 eine Positionsmesseinrichtung 3 zur Erfassung der Position des Messkontaktes innerhalb des Hohlkörpers 2 zugeordnet.

Mittels zweier (nicht dargestellter) Geberelektroden kann dem Erdreich bzw. Deponiematerial, das an der den schlauchförmigen Hohlkörpern 2 abgewandten Seite der Deponieabdichtung 1 anliegt, ein elektrisches Strömungsfeld aufgeprägt werden. Befindet sich in der Deponieabdichtung 1 ein Leck, so wird das elektrische Strömungsfeld über das Leck auf einen Bereich des Erdreichs auf der anderen Seite der Deponieabdichtung 1 übertragen, an welchem die schlauchförmigen Hohlkörper 2 anliegen. An dem Leck bildet sich im Erdreich außerhalb der Deponieabdichtung 1 somit ein elektrisches Strömungsfeld, dessen Stärke (Potenzial) mit zunehmender Entfernung vom Leck abnimmt. In der erdberührenden Wandung des jeweiligen schlauchförmigen Hohlkörpers 2 entsteht demzufolge ein elektrisches Potenzial, das dem Erdpotenzial an gleicher Stelle entspricht. Da die Wandung des Hohlkörpers 2 elektrisch leitfähig ist, ist wiederum das elektrische Potenzial an der Innenseite der Wandung proportional dem Potenzial an der Außenseite der Wandung. Mit einem längsverschiebbaren Messkontakt kann das Potenzial in einfacher Weise ortsbezogen abgetastet und gemessen werden.

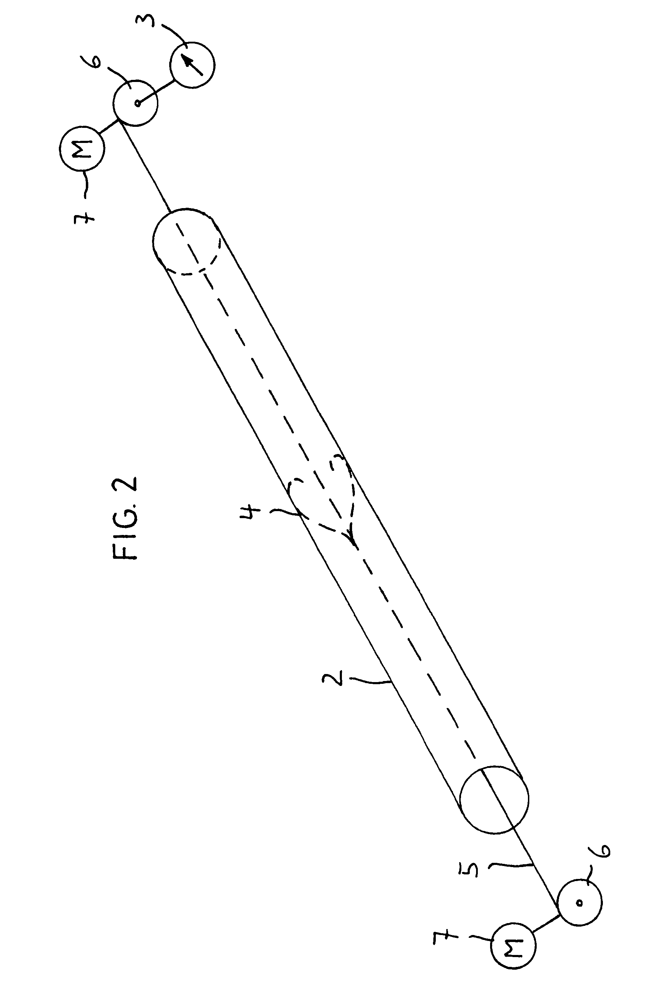

Der längsverschiebbare Messkontakt kann auf verschiedene Weise realisiert werden. In Fig. 2 ist eine Ausführungsform gezeigt, bei der der längsverschiebbare Messkontakt als elektrischer Schleifkontakt 4 ausgebildet ist. Der in Strichlinien dargestellte Schleifkontakt 4 hat zwei nach außen vorgespannte federelastische Schenkel aus elektrisch leitfähigem Material, die nach innen gebogene Enden aufweisen. Der Schleifkontakt 4 ist an einem zug- und/oder schubkraftübertragenden Mittel 5, beispielsweise einem Seil oder Draht, elektrisch leitend befestigt. Das zug- und/oder schubkraftübertragenden Mittel 5 selbst ist ebenfalls elektrisch leitfähig und vorzugsweise mit Kunststoff oder einem anderen elektrischen Isolator ummantelt. Die beiden Enden des zug- und/oder schubkraftübertragenden Mittels 5 sind an Wickelrollen 6 befestigt, die durch gleichsinnig drehende Motoren 7 angetrieben werden. Mindestens eines der beiden Enden des zug- und/oder schubkraftübertragenden Mittels 5 ist an einer Messeinrichtung 3 angeschlossen, mit der das elektrische Potenzial der Wandung des schlauchförmigen Hohlkörpers 2 im Bereich des Schleifkontaktes 4 sowie die Position des Schleifkontaktes 4 innerhalb des Hohlkörpers 2 gemessen wird. Die Position des Schleifkontaktes 4 im Hohlkörper 2 kann dabei insbesondere durch eine Längenmessung des zug- und/oder schubkraftübertragenden Mittels 5 erfolgen.

Die Wandung des Hohlkörpers 2 weist bei der Ausführungsform gemäß Fig. 2 eine elektrische Leitfähigkeit auf, die gleich oder geringer ist, als die Leitfähigkeit des geoelektrisch wirksamen Volumens des Erdreichs entlang der durch den Hohlkörper 2 definierten Messstrecke.

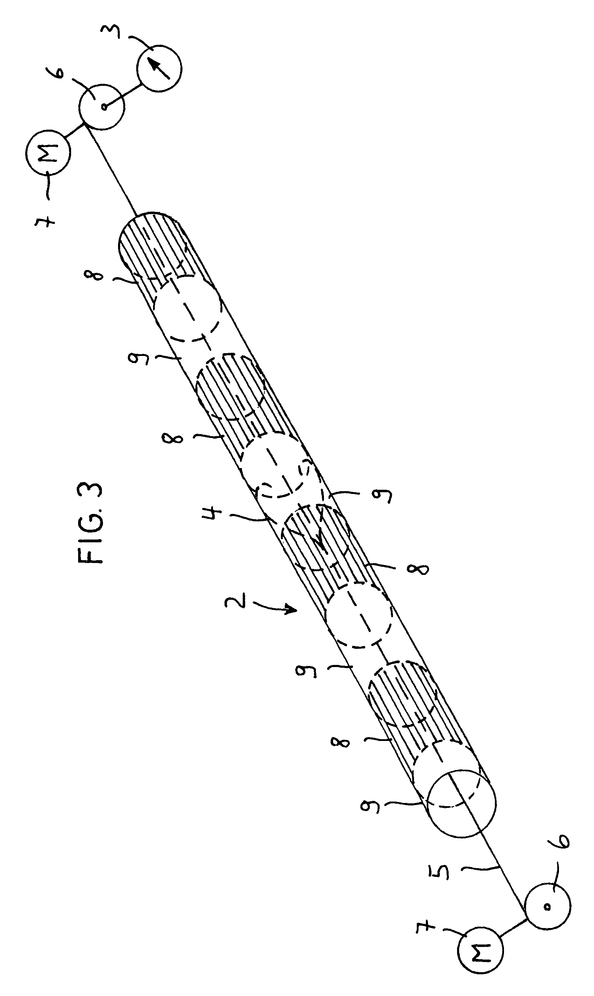

Fig. 3 zeigt eine Ausführungsform, die sich von derjenigen gemäß Fig. 2 dadurch unterscheidet, dass der flexible, schlauchförmige Hohlkörper 2 axial sich abwechselnde elektrisch leitfähige Wandungsabschnitte 8 und elektrisch nicht leitfähige Wandungsabschnitte 9 aufweist. Die elektrisch leitfähigen und elektrisch nicht leitfähigen Abschnitte 8, 9 haben dabei jeweils die gleiche Länge. Ist die Länge der jeweils leitfähigen und nicht leitfähigen Wandungsabschnitte 8, 9 bekannt, so kann durch Auszählen der Fenster (Abschnitte) mit und ohne Potenzialverbindung, welche der längsverschiebbare Schleifkontakt 4 bei einer Verschiebung im Hohlkörper 2 überstrichen hat, in einfacher Weise die zu einem Potenzialmesswert zugehörige Position des Schleifkontaktes 4 im Hohlkörper 2 bestimmt werden.

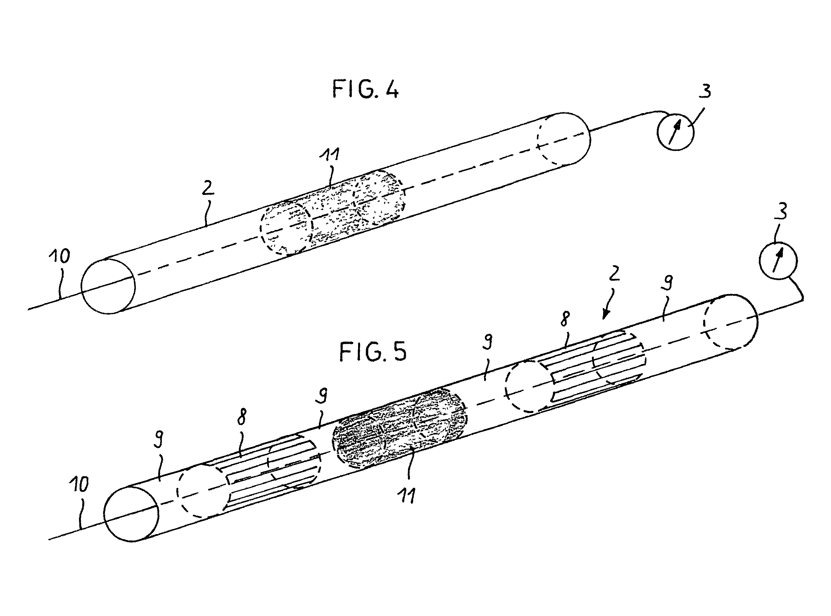

Fig. 4 zeigt gegenüber den Figuren 2 und 3 eine alternative Ausführungsform. Bei dieser Ausführungsform ist der flexible, schlauchförmige Hohlkörper 2 mit einem in Längsrichtung verlaufenden, elektrisch leitfähigen Kontaktleiter 10 versehen, der zum Innenraum des Hohlkörpers 2 zumindest abschnittsweise keine elektrische Isolierung aufweist, jedoch aufgrund seiner Anordnung und/oder Befestigung gegenüber den elektrisch leitfähigen Bereichen der Hohlkörperwandung keinen unmittelbaren elektrischen Kontakt aufweist. Der Kontaktleiter 10 ist an einem freien Ende des Hohlkörpers 2 an einer Messeinrichtung 3 angeschlossen, mittels der das elektrische Potenzial des an die Außenseite des Hohlkörpers 2 angrenzenden Erdreichs sowie die Position eines an der Innenseite des Hohlkörpers 2 anliegenden, entlang des Hohlkörpers 2 verschiebbaren Messkontaktes messbar ist. Der längsverschiebbare Messkontakt wird dabei durch eine elektrisch leitfähige Kontaktflüssigkeit 11 realisiert, die innerhalb des Hohlkörpers 2 eine Flüssigkeitssäule bildet, deren Länge im Vergleich zur Länge des Hohlkörpers 2 sehr gering ist, zum Beispiel nur einige Zentimeter beträgt.

Eine geeignete Kontaktflüssigkeit ist beispielsweise Quecksilber. Am jeweiligen Ort der Kontaktflüssigkeit 11 wird zwischen dem Kontaktleiter 10 und der Wandung des Hohlkörpers 2 eine elektrische Verbindung hergestellt, so dass ein im Bereich der Kontaktflüssigkeit 11 in der Wandung des Hohlkörpers 2 vorhandenes elektrisches Potenzial über den Kontaktleiter 10 durch die damit verbundene Messeinrichtung 3 gemessen werden kann. Die Kontaktflüssigkeit 11 besitzt in Bezug auf die Wandung des Hohlkörpers 2 und den Kontaktleiter eine so geringe Benetzungsneigung, dass die von ihr gebildete Flüssigkeitssäule bei einer Verschiebung innerhalb des Hohlkörpers 2 nicht zerteilt wird.

Die Verschiebung der Flüssigkeitssäule in Längsrichtung des Hohlkörpers 2 kann hydraulisch oder pneumatisch erfolgen, indem der Hohlkörper 2 vor oder hinter der aus der Kontaktflüssigkeit 11 bestehenden Flüssigkeitssäule mit einer unter Über- oder Unterdruck stehenden Flüssigkeits- oder Druckgassäule beaufschlagt wird. Die erfindungsgemäße Vorrichtung ist dementsprechend mit einer Pumpe bzw. einem Gebläse ausgestattet.

Bei der in Fig. 4 dargestellten Ausführungsform weist die Wandung des Hohlkörpers 2 eine elektrische Leitfähigkeit auf, die gleich oder geringer ist, als die Leitfähigkeit des geoelektrisch wirksamen Volumens des den Hohlkörper 2 umgebenden Erdreichs. Der Kontaktleiter 10 weist einen längenproportionalen elektrischen Widerstand auf, so dass die Position der Kontaktflüssigkeit 11 im Hohlkörper 2 durch Messen des längenabhängigen Schleifenwiderstandes des Kontaktleiters 10 gegen Erde bestimmt werden kann. Alternativ kann die Position der Kontaktflüssigkeit 11 auch aus dem positionsabhängigen Widerstandsverhältnis der von beiden freien Enden des Kontaktleiters 10 über die Kontaktflüssigkeit 11 gegen Erde gemessenen Schleifenwiderstände bestimmt werden.

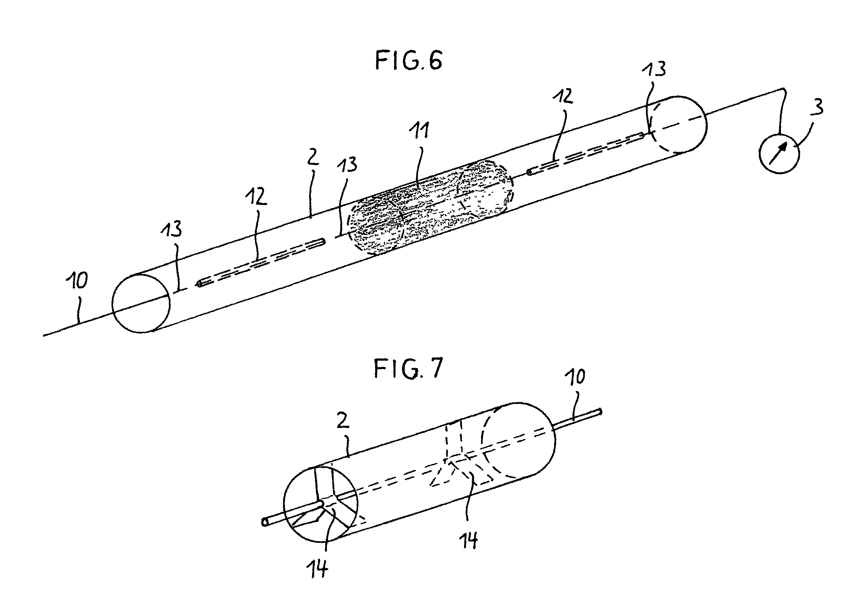

Eine weitere Möglichkeit, die Position der Kontaktflüssigkeit 11 im Hohlkörper 2 zu bestimmen, ist in Fig. 5 dargestellt. Bei dieser Ausführungsform wird die Position der Kontaktflüssigkeit im Hohlkörper, ähnlich der Ausführungsform mit Schleifkontakt gemäß Fig. 3, durch Auszählen sich abwechselnder leitfähiger und nicht leitfähiger Wandungsabschnitte 8, 9 des Hohlkörpers 2 oder deren Überprägung im Messdatenverlauf ermittelt. In einer alternativen Ausführungsform hierzu kann der Kontaktleiter 10, wie in Fig. 6 gezeigt, sich abwechselnde elektrisch isolierte Abschnitte 12 und elektrisch nicht isolierte Abschnitte 13 aufweisen, die jeweils eine vorgegebene einheitliche Länge aufweisen, so dass die Position der Kontaktflüssigkeit 11 im Hohlkörper 2 in entsprechender Weise durch Auszählen der sich abwechselnden elektrisch isolierten und elektrisch nicht isolierten Abschnitte 12, 13 des Kontaktleiters 10 oder deren Überprägung im Messdatenverlauf ermittelt werden kann.

Die Flüssigkeitssäule der Kontaktflüssigkeit 11 ist bei den Ausführungsformen gemäß den Figuren 5 und 6 so bemessen, dass ihre Länge kürzer ist als die Länge der sich abwechselnden elektrisch leitfähigen und elektrisch nicht leitfähigen Wandungsabschnitte 8, 9 des Hohlkörpers 2 bzw. der sich abwechselnden elektrisch isolierten und elektrisch nicht isolierten Abschnitte 12, 13 des Kontaktleiters 10. Hierdurch wird eine eindeutige Auszählung der sich abwechselnden Abschnitte 8, 9 bzw. 12, 13 sichergestellt.

In den Figuren 7 bis 9 sind verschiedene Ausführungsformen dargestellt, die die Anordnung bzw. Befestigung des elektrisch leitfähigen Kontaktleiters 10 gegenüber elektrisch leitfähigen Bereichen der Hohlkörperwandung veranschaulichen. Bei der Ausführungsform gemäß Figur 7 ist der Kontaktleiter 10 im Wesentlichen zentrisch innerhalb des schlauchförmigen Hohlkörpers 2 angeordnet, wobei er durch eine Vielzahl von Haltern 14 aus elektrisch nicht leitendem Material von den elektrisch leitfähigen Bereichen der Hohlkörperwandung elektrisch getrennt ist. Die Halter 14 weisen jeweils drei Arme auf, die im Wesentlichen gleichmäßig zueinander beabstandet sind und einen Umfangskreis definieren, dessen Durchmesser geringfügig kleiner als der Innendurchmesser des schlauchförmigen Hohlkörpers 2 ist.

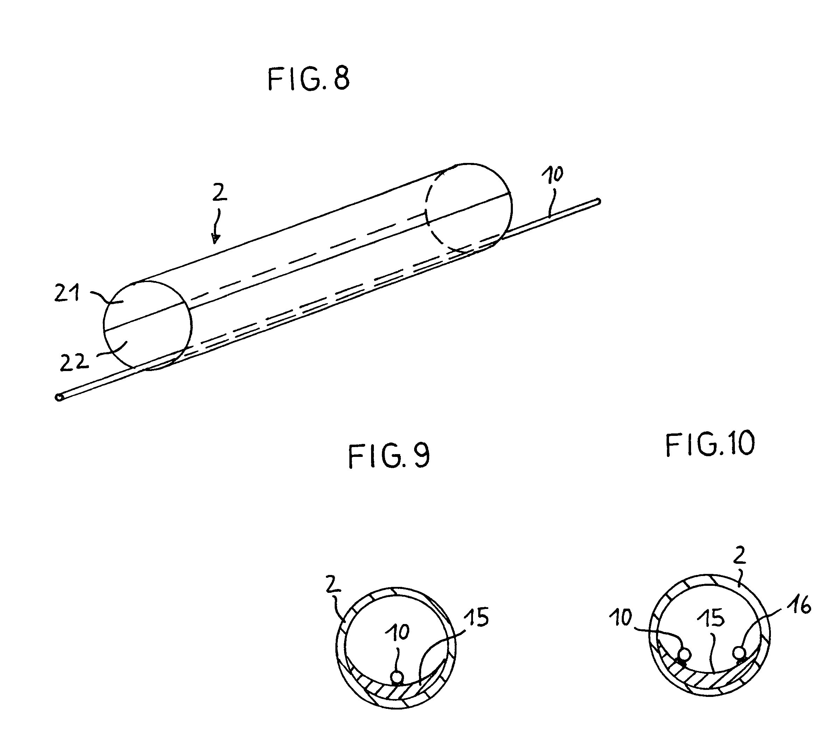

Bei der Ausführungsform gemäß Fig. 8 ist der schlauchförmige Hohlkörper 2 über seinen Umfang in einen elektrisch leitfähigen Wandungsabschnitt 21 und einen elektrisch nicht leitfähigen Wandungsabschnitt 22 unterteilt, wobei der elektrisch leitfähige Kontaktleiter 10 an der Innenseite des elektrisch nicht leitfähigen Wandungsabschnittes 22 durch (nicht dargestellte) Befestigungsmittel fixiert ist.

Bei der Ausführungsform gemäß Fig. 9 ist in dem schlauchförmigen, aus elektrisch leitfähigem Material hergestellten Hohlkörper 2 ein langgestreckter, elektrisch nicht leitfähiger, im Querschnitt sichelförmiger Halter 15 angeordnet, an dessen Innenseite ein elektrisch leitfähiger Kontaktleiter 10 fixiert ist.

Die Ausführungsform gemäß Fig. 10 unterscheidet sich von der Ausführungsform gemäß Fig. 9 dadurch, dass in dem Hohlkörper 2 ein weiterer Leiter 16, der gegenüber dem Kontaktleiter 10 und der Hohlkörperwandung elektrisch isoliert ist, als längenproportionales Widerstandselement angeordnet ist. Der Leiter 16 dient der Positionsbestimmung der Kontaktflüssigkeit innerhalb des Hohlkörpers 2. Die Position der Kontaktflüssigkeit wird dabei durch Messen des längenabhängigen Schleifenwiderstandes des Leiters 16 gegen Erde oder aus dem positionsabhängigen Widerstandsverhältnis der von beiden freien Enden des Leiters 16 gegen Erde gemessenen Schleifenwiderstände bestimmt.

Die Erfindung ist in ihrer Ausführung nicht auf die vorstehend beschriebenen Ausführungsformen beschränkt. Vielmehr sind verschiedene Varianten denkbar, die auch bei grundsätzlich abweichender Gestaltung von dem in den beiliegenden Ansprüchen definierten Erfindungsgedanken Gebrauch machen. So kann beispielsweise die Position der Kontaktflüssigkeit 11 im Hohlkörper 2 auch durch Messen eines zur Verschiebung der Kontaktflüssigkeit 11 in den Hohlkörper 2 eingebrachten Fluidvolumens und/oder eines durch die Kontaktflüssigkeit 11 aus dem Hohlkörper 2 verdrängten Fluidvolumens bestimmt werden. Des Weiteren kann es zweckmäßig sein, die Geschwindigkeit der Verschiebung der Kontaktflüssigkeit 11 durch Drosselung eines in dem Hohlkörper 2 ein- oder ausströmenden Fluids zu steuern.

Die Verwendung einer Kontaktflüssigkeit 11 bietet im Übrigen auch die Möglichkeit, den Höhenverlauf des Hohlkörpers 2 durch Erfassung des Druckverlaufes der Kontaktflüssigkeit 11 im Hohlkörper zu bestimmen. Anhand des Höhenverlaufes des jeweiligen Hohlkörpers 2 können Höhenlageveränderungen und damit Setzungen des Hohlkörpers bzw. einer zugeordneten Deponieabdichtung erfasst werden.

## Patentansprüche

1. Vorrichtung zur ortsbezogenen Messung von elektrischen Eigen- und Fremdpotenzialen im Erdreich,
**gekennzeichnet durch**
eine Vielzahl von langgestreckten, jeweils eine Messstrecke definierenden flexiblen Hohlkörpern (2) aus Kunststoff, die im wesentlichen parallel zueinander angeordnet sind und jeweils eine zumindest abschnittsweise elektrisch leitfähige Wandung aufweisen, und mindestens einen an der Innenseite des jeweiligen Hohlkörpers anliegenden, entlang des Hohlkörpers verschiebbaren Messkontakt (4, 11).

2. Vorrichtung nach Anspruch 1, des weiteren
**gekennzeichnet durch**
mindestens eine Positionsmesseinrichtung (3) zur Erfassung der Position des Messkontaktes (4, 11) innerhalb des jeweiligen Hohlkörpers (2).

3. Vorrichtung nach Anspruch 1 oder 2,
**dadurch gekennzeichnet, dass** die Hohlkörper (2) jeweils sich axial und/oder über ihren Umfang abwechselnde elektrisch leitfähige und elektrisch nicht leitfähige Wandungsabschnitte (8, 9) aufweisen.

4. Vorrichtung nach einem der Ansprüche 1 bis 3,
**dadurch gekennzeichnet, dass** die Hohlkörper (2) jeweils mit einem in Längsrichtung verlaufenden, elektrisch leitfähigen Kontaktleiter (10) versehen sind, der zum Innenraum des jeweiligen Hohlkörpers (2) zumindest abschnittsweise keine elektrische Isolierung aufweist, jedoch aufgrund seiner Anordnung und/oder Befestigung gegenüber den elektrisch leitfähigen Bereichen der Hohlkörperwandung keinen unmittelbaren elektrischen Kontakt aufweist.

5. Vorrichtung nach Anspruch 4,
**dadurch gekennzeichnet, dass** in dem jeweiligen Hohlkörper (2) ein weiterer Leiter (16), der gegenüber dem Kontaktleiter (10) und der Hohlkörperwandung elektrisch isoliert ist, als längenproportionales Widerstandselement angeordnet ist.

6. Vorrichtung nach einem der Ansprüche 1 bis 5,
**dadurch gekennzeichnet, dass** der Messkontakt (11) durch eine elektrisch leitfähige Kontaktflüssigkeit realisiert ist, die innerhalb des jeweiligen Hohlkörpers (2) eine Flüssigkeitssäule bildet, deren Länge ein Bruchteil der Länge des jeweiligen Hohlkörpers (2) ist.

7. Verfahren zur ortsbezogenen Messung von elektrischen Eigen- und Fremdpotenzialen im Erdreich,
**dadurch gekennzeichnet, dass** eine Vielzahl von langgestreckten, jeweils eine Messstrecke definierenden flexiblen Hohlkörpern (2) aus Kunststoff, die eine zumindest abschnittsweise elektrisch leitfähige Wandung aufweisen, im wesentlichen parallel zueinander im Erdreich verlegt oder am Erdreich angelegt werden, und
dass das elektrische Potenzial des an den jeweiligen Hohlkörper (2) angrenzenden Erdreiches mittels eines an der Innenseite des jeweiligen Hohlkörpers anliegenden, entlang des jeweiligen Hohlkörpers (2) verschiebbaren Messkontaktes (4, 11) gemessen wird.

8. Verfahren nach Anspruch 7,
**dadurch gekennzeichnet, dass** die Hohlkörper (2) jeweils mit einem in Längsrichtung verlaufenden, elektrisch leitfähigen Kontaktleiter (10) versehen sind, der zum Innenraum des jeweiligen Hohlkörpers (2) zumindest abschnittsweise keine elektrische Isolierung aufweist, jedoch aufgrund seiner Anordnung und/oder Befestigung gegenüber den elektrisch leitfähigen Bereichen der Hohlkörperwandung keinen unmittelbaren elektrischen Kontakt aufweist, und dass als verschiebbarer Messkontakt eine elektrisch leitfähige Kontaktflüssigkeit (11) verwendet wird, die innerhalb des jeweiligen Hohlkörpers (2) eine Flüssigkeitssäule bildet, deren Länge ein Bruchteil der Länge des jeweiligen Hohlkörpers (2) ist.

9. Verfahren nach einem der Ansprüche 7 oder 8,
**dadurch gekennzeichnet, dass** der jeweilige Hohlkörper (2) in seiner Längsrichtung sich abwechselnde elektrisch leitfähige und elektrisch nicht leitfähige Wandungsabschnitte (8, 9) aufweist, und dass die Position des Messkontaktes (11) im jeweiligen Hohlkörper (2) durch Auszählen der sich abwechselnden leitfähigen und nicht leitfähigen Wandungsabschnitte (8, 9) des Hohlkörpers (2) oder deren Überprägung im Messdatenverlauf ermittelt wird.

10. Verfahren nach Anspruch 8,
**dadurch gekennzeichnet, dass** der Kontaktleiter (10) sich abwechselnde elektrisch isolierte Abschnitte (12) und elektrisch nicht isolierte Abschnitte (13) aufweist, und dass die Position der Kontaktflüssigkeit (11) im Hohlkörper (2) durch Auszählen der sich abwechselnden elektrisch isolierten und elektrisch nicht isolierten Abschnitte (12, 13) des Kontaktleiters (10) oder deren Überprägung im Messdatenverlauf ermittelt wird.

11. Verfahren nach Anspruch 8,
**dadurch gekennzeichnet, dass** der Kontaktleiter (10) einen längenproportionalen elektrischen Widerstand aufweist, und dass die Position der Kontaktflüssigkeit im jeweiligen Hohlkörper (2) durch Messen des längenabhängigen Schleifenwiderstandes des Kontaktleiters (10) gegen Erde oder aus dem positionsabhängigen Widerstandsverhältnis der von beiden freien Enden des Kontaktleiters (10) über die Kontaktflüssigkeit (11) gegen Erde gemessenen Schleifenwiderstände bestimmt wird.

12. Verfahren nach Anspruch 8,
**dadurch gekennzeichnet, dass** in dem jeweiligen Hohlkörper ein weiterer Leiter (16), der gegenüber dem Kontaktleiter (10) und der Hohlkörperwandung elektrisch isoliert ist, als längenproportionales Widerstandselement angeordnet ist, und dass die Position der Kontaktflüssigkeit (11) im jeweiligen Hohlkörper (2) durch Messen des längenabhängigen Schleifenwiderstandes des weiteren Leiters (16) gegen Erde oder aus dem positionsabhängigen Widerstandsverhältnis der von beiden freien Enden des weiteren Leiters (16) gegen Erde gemessenen Schleifenwiderstände bestimmt wird.

13. Verfahren nach einem der Ansprüche 8 bis 12
**dadurch gekennzeichnet, dass** die Geschwindigkeit der Verschiebung der Kontaktflüssigkeit (11) durch Drosselung eines in den jeweiligen Hohlkörper (2) ein- oder ausströmenden Fluids gesteuert wird.

14. Verfahren nach einem der Ansprüche 8 bis 13,
**dadurch gekennzeichnet, dass** die Position der Kontaktflüssigkeit (11) im jeweiligen Hohlkörper (2) durch Messen eines zur Verschiebung der Kontaktflüssigkeit (11) in den jeweiligen Hohlkörper (2) eingebrachten Fluidvolumens und/oder eines durch die Kontaktflüssigkeit (11) aus dem jeweiligen Hohlkörper (2) verdrängten Fluidvolumens bestimmt wird.

## Claims

1. A device for the locally related measurement of electric natural potentials and artificial potentials in the soil,
**characterized in**
a plurality of elongated, flexible hollow bodies (2) of plastic that respectively define a measuring section, wherein said hollow bodies are essentially arranged parallel to one another and respectively have a wall that is at least sectionally realized in an electrically conductive fashion, and in at least one measuring contact (4, 11) that adjoins the inner side of the respective hollow body and can be displaced along the hollow body.

2. The device according to Claim 1, additionally
**characterized in**
at least one position measuring device (3) for determining the position of the measuring contact (4, 11) within the respective hollow body (2).

3. The device according to Claim 1 or 2,
**characterized in that** the hollow bodies (2) respectively comprise electrically conductive and non-conductive wall sections (8, 9) that alternate in the axial and/or circumferential direction.

4. The device according to one of Claims 1 to 3,
**characterized in that** the hollow bodies (2) are respectively provided with an electrically conductive contact conductor (10) that extends in the longitudinal direction and at least sectionally has no electric insulation relative to the interior of the respective hollow body (2), but also makes no direct electric contact due to its arrangement and/or mounting relative to the electrically conductive sections of the hollow body wall.

5. The device according to Claim 4,
**characterized in that** an additional conductor (16) is arranged in the respective hollow body (2), wherein this additional conductor is electrically insulated relative to the contact conductor (10) and the hollow body wall and serves as a length-proportional resistance element.

6. The device according to any one of Claims 1 to 5,
**characterized in that** the measuring contact (11) is realized in the form of an electrically conductive contact liquid that forms a liquid column within the respective hollow body (2), wherein the length of said liquid column amounts to a fraction of the length of the respective hollow body (2).

7. A method for the locally related measurement of electric natural potentials and artificial potentials in the soil,
**characterized in that** a plurality of elongated, flexible hollow bodies (2) of plastic that respectively define a measuring section and have a wall that is at least sectionally realized in an electrically conductive fashion are essentially installed in or placed against the soil parallel to one another, and **in that** the electric potential of the soil situated adjacent to the respective hollow body (2) is measured with a measuring contact (4, 11) that adjoins the inner side of the respective hollow body and can be displaced along the respective hollow body (2).

8. The method according to Claim 7,
**characterized in that** the hollow bodies (2) are respectively provided with an electrically conductive contact conductor (10) that extends in the longitudinal direction and at least sectionally has no electric insulation relative to the interior of the respective hollow body (2), but also makes no direct electric contact due to its arrangement and/or mounting relative to the electrically conductive sections of the hollow body wall, and **in that** an electrically conductive contact liquid (11) that forms a liquid column within the respective hollow body (2) is used as the displaceable measuring contact, wherein the length of said liquid column amounts to a fraction of the length of the respective hollow body (2).

9. The method according to Claim 7 or 8,
**characterized in that** the respective hollow body (2) comprises electrically conductive and non-conductive wall sections (8, 9) that alternate in its longitudinal direction, and **in that** the position of the measuring contact (11) in the respective hollow body (2) is determined by counting out the alternating conductive and non-conductive wall sections (8, 9) of the hollow body (2) or their superposition in the measuring data characteristic.

10. The method according to Claim 8,
**characterized in that** the contact conductor (10) has alternating electrically insulated sections (12) and non-insulated sections (13), and **in that** the position of the contact liquid (11) in the hollow body (2) is determined by counting out the alternating electrically insulated and non-insulated sections (12, 13) of the contact conductor (10) or their superposition in the measuring data characteristic.

11. The method according to Claim 8,
**characterized in that** the contact conductor (10) has a length-proportional electrical resistance, and **in that** the position of the contact liquid in the respective hollow body (2) is determined by measuring the length-dependent loop resistance of the contact conductor (10) relative to earth or from the position-dependent resistance ratio of the loop resistances measured from both free ends of the contact conductor (10) to earth via the contact liquid (11).

12. The method according to Claim 8,
**characterized in that** an additional conductor (16) is arranged in the respective hollow body, wherein this additional conductor is electrically insulated relative to the contact conductor (10) and the hollow body wall and serves as a length-proportional resistance element, and **in that** the position of the contact liquid (11) in the respective hollow body (2) is determined by measuring the length-dependent loop resistance of the additional conductor (16) relative to earth or from the position-dependent resistance ratio of the loop resistances measured from both free ends of the additional conductor (16) to earth.

13. The method according to one of Claims 8 to 12,
**characterized in that** the displacement speed of the contact liquid (11) is controlled by throttling a fluid that flows into or out of the respective hollow body (2).

14. The method according to one of Claims 8 to 13,
**characterized in that** the position of the contact liquid (11) in the respective hollow body (2) is determined by measuring a fluid volume introduced into the respective hollow body (2) in order to displace the contact liquid (11) and/or a fluid volume displaced from the respective hollow body (2) by the contact liquid (11).

## Revendications

1. Dispositif de mesure localisée de potentiels électriques naturelles et extérieurs dans la terre,
**caractérisé par** une multitude de corps creux flexibles (2) et étirés à la longueur en matière plastique, définissant chacun une section de mesure, qui sont disposés sensiblement parallèlement les uns par rapport aux autres et présentent chacun une paroi conductrice d'électricité du moins par sections, et au moins un contact de mesure (4, 11) touchant la face interne du corps creux respectif et déplaçable le long du corps creux.

2. Dispositif selon la revendication 1,
**caractérisé en outre par** au moins un dispositif de mesure de position (3) pour enregistrer la position du contact de mesure (4, 11) à l'intérieur du corps creux respectif (2).

3. Dispositif selon la revendication 1 ou 2,
**caractérisé en ce que** les corps creux (2) présentent des sections de paroi conductrices d'électricité et non conductrices d'électricité (8, 9) alternant respectivement axialement et/ou sur leur circonférence.

4. Dispositif selon l'une quelconque des revendications 1 à 3,
**caractérisé en ce que** les corps creux (2) sont munis chacun d'un conducteur de contact conducteur d'électricité (10), s'étendant respectivement dans le sens longitudinal, qui, du moins par sections, ne présente pas d'isolation électrique vis-à-vis de l'intérieur du corps creux respectif (2) mais, du fait de sa disposition et/ou de sa fixation, ne présente pas de contact électrique direct vis-à-vis des zones conductrices d'électricité de la paroi du corps creux.

5. Dispositif selon la revendication 4,
**caractérisé en ce que**, dans le corps creux respectif (2), est disposé, sous forme d'un élément de résistance proportionnel à la longueur, un autre conducteur (16) qui est isolé électriquement par rapport au conducteur de contact (10) et à la paroi du corps creux.

6. Dispositif selon l'une quelconque des revendications 1 à 5,
**caractérisé en ce que** le contact de mesure (11) est réalisé par un liquide de contact conducteur d'électricité qui constitue à l'intérieur du corps creux respectif (2) une colonne de liquide dont la longueur est une fraction de la longueur du corps creux respectif (2).

7. Procédé de mesure localisée de potentiels électriques naturelles et extérieurs dans la terre,
**caractérisé en ce qu'**une multitude de corps creux flexibles (2) étirés en longueur en matière plastique, définissant chacun une section de mesure, qui présentent une paroi conductrice d'électricité au moins par sections, sont posés sensiblement parallèlement les uns aux autres dans la terre ou sur la terre, et que le potentiel électrique de la terre adjacente au corps creux respectif (2) est mesuré au moyen d'un contact de mesure (4, 11) touchant la face interne du corps creux respectif et déplaçable le long du corps creux respectif (2).

8. Procédé selon la revendication 7,
**caractérisé en ce que** les corps creux (2) sont munis chacun d'un conducteur de contact (10) conducteur d'électricité et s'étendant dans le sens longitudinal qui ne présente pas d'isolation vis-à-vis de l'espace intérieur du corps creux respectif (2) mais, du fait de sa disposition et/ou de sa fixation, ne présente pas de contact électrique direct vis-à-vis des zones conductrices d'électricité de la paroi du corps creux, et qu'on utilise comme contact de mesure déplaçable un liquide de contact conducteur d'électricité (11) qui constitue à l'intérieur du corps creux respectif (2) une colonne de liquide dont la longueur est une fraction de la longueur du corps creux respectif (2).

9. Procédé selon l'une quelconque des revendications 7 ou 8,
**caractérisé en ce que** le corps creux respectif (2) présente des sections de paroi conductrices d'électricité et non conductrices d'électricité (8, 9) alternant dans son sens longitudinal, et que la position du contact de mesure (11) est déterminée par comptage des sections de paroi (8, 9) conductrices et non conductrices d'électricité alternantes du corps creux (2) ou de leur surimpression dans l'évolution des données de mesure.

10. Procédé selon la revendication 8,
**caractérisé en ce que** le conducteur de contact (10) présente des sections (12) isolées au niveau électrique et non isolées au niveau électrique alternantes (13), et que la position du liquide de contact (11) dans le corps creux (2) est déterminée par comptage des sections isolées au niveau électrique et non isolées au niveau électrique alternantes (12, 13) du conducteur de contact (10) ou de leur surimpression dans l'évolution des données de mesure.

11. Procédé selon la revendication 8,
**caractérisé en ce que** le conducteur de contact (10) présente une résistance électrique proportionnelle à la longueur, et que la position du liquide de contact dans le corps creux respectif (2) est déterminée en mesurant la résistance de boucle liée à la longueur du conducteur de contact (10) à la terre ou à partir du rapport de résistance lié à la position des résistances de boucle mesurées par les deux extrémités libres du conducteur de contact (10) par le biais du liquide de contact (11) à la terre.

12. Procédé selon la revendication 8,
**caractérisé en ce que**, dans le corps creux respectif, un autre conducteur (16), qui est isolé au niveau électrique vis-à-vis du conducteur de contact (10) et de la paroi du corps creux, est disposé sous forme d'un élément de résistance proportionnel à la longueur, et que la position du liquide de contact (11) dans le corps creux respectif (2) est définie en mesurant la résistance de boucle liée à la longueur de l'autre conducteur (16) à la terre ou à partir du rapport de résistance lié à la position des résistances de boucle mesurées par les deux extrémités libres de l'autre conducteur (16) à la terre.

13. Procédé selon l'une quelconque des revendications 8 à 12,
**caractérisé en ce que** la vitesse de déplacement du liquide de contact (11) est commandée par étranglement d'un fluide affluant dans le corps creux respectif (2) ou en sortant.

14. Procédé selon l'une quelconque des revendications 8 à 13,
**caractérisé en ce que** la position du liquide de contact (11) dans le corps creux respectif (2) est définie en mesurant un volume de fluide introduit dans le corps creux respectif (2) pour déplacer le liquide de contact (11) et/ou un volume de fluide refoulé par le liquide de contact (11) hors du corps creux respectif (2).
